# FASCICULE DE BREVET EUROPEEN

(11) **EP 0 743 754 B1**
(45) Date de publication et mention de la délivrance du brevet: **17.01.2001**
(21) Numéro de dépôt: 96410052.3
(22) Date de dépôt: 15.05.1996
(51) Int. Cl.: H03K 17/725, H05B 41/04

(54) **Circuit de démarrage d'un tube fluorescent**
Leuchtstoffröhren-Starterschaltung
Starter circuit of a fluorescent tube

(30) Priorité: 19.05.1995 FR 9506265
(43) Date de publication de la demande: 20.11.1996
(73) Titulaire: STMicroelectronics S.A., 94250 Gentilly (FR)
(72) Inventeur: Pezzani, Robert, 37210 Vouvray (FR)
(74) Mandataire: de Beaumont, Michel

(56) Documents cités:
- FR-A- 2 541 843
- US-A- 4 503 359
- US-A- 5 023 521

## Description

La présente invention concerne un circuit de démarrage de tube fluorescent et sa réalisation sous forme de composant monolithique.

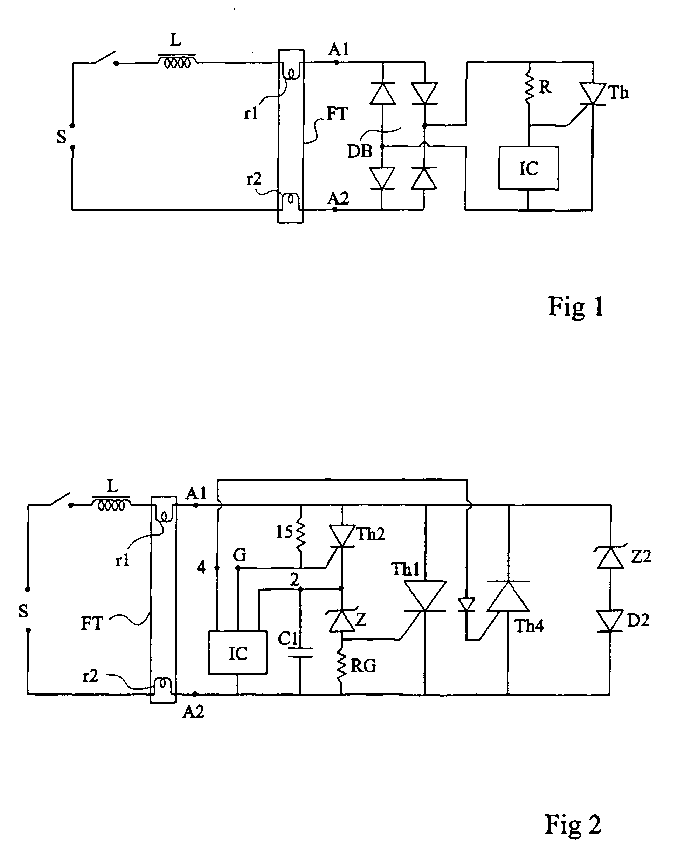

La figure 1 représente un schéma classique de circuit de démarrage de tube fluorescent (tube néon) à interrupteur statique. Le tube fluorescent FT comprend deux électrodes séparées par un gaz dans lequel est susceptible de se produire une fluorescence. Ces électrodes correspondent respectivement à des filaments résistifs r1 et r2. La première borne du filament r1 est connectée à une source de tension alternative S (généralement la tension du secteur) par l'intermédiaire d'une bobine L et d'un interrupteur de mise en route (non référencé). La première borne du filament r2 est connectée à la deuxième borne de la source S. Les deuxièmes bornes, A1 et A2, des filaments r1 et r2 sont connectées aux entrées alternatives d'un pont de diodes redresseur DB. Les bornes continues du pont redresseur DB sont connectées à un interrupteur qui, dans le mode de réalisation illustré, est constitué d'un thyristor Th. La gâchette du thyristor est reliée à la borne positive du pont par une résistance R et à la borne négative du pont par un circuit intégré de commande IC.

Dès que le circuit est mis sous tension, le thyristor Th est mis en conduction par un courant traversant la résistance R. En conséquence, un courant circule dans les filaments r1 et r2 et les chauffe. Dans une phase d'allumage, le thyristor Th est ouvert en cours d'alternance sous l'effet du circuit intégré qui court-circuite ses bornes de gâchette et de cathode. L'inductance L tend alors à maintenir le courant qui la traversait au moment de l'ouverture. La tension entre les bornes A1 et A2 croît donc rapidement et le tube fluorescent s'amorce. Une fois cet amorçage obtenu, le thyristor Th reste ouvert et le tube fluorescent se réamorce de lui-même à chaque alternance.

Un tel circuit présente plusieurs inconvénients.

Un premier inconvénient est que la chute de tension dans le circuit d'interrupteur statique est élevée car elle correspond à deux chutes de tension de diodes plus la chute de tension dans le thyristor à l'état passant.

Un autre inconvénient réside dans le fait qu'il faut prévoir une alimentation séparée pour le circuit intégré de commande.

Ainsi, un objet de la présente invention est de prévoir un module de démarrage de tube fluorescent qui pallie ces inconvénients.

Un autre objet de la présente invention est de prévoir un tel module qui soit réalisable sous forme d'un composant semiconducteur monolithique.

Pour atteindre ces objets, la présente invention prévoit un module de démarrage d'un tube fluorescent associé à un circuit de charge comprenant une source d'alimentation alternative en série avec une inductance ballast et un premier et un deuxième filament du tube fluorescent. Ce module est connecté entre les deuxièmes bornes des filaments et comprend :
entre les deuxièmes bornes, un premier et un deuxième thyristor principal tête-bêche respectivement à gâchette de cathode et à gâchette d'anode, et une diode Zener de protection en série avec une diode,
un circuit intégré de commande,
la gâchette du premier thyristor étant connectée à l'une des deuxièmes bornes et à sa cathode par l'intermédiaire d'une résistance et à l'autre des deuxièmes bornes par la connexion en série d'un thyristor auxiliaire et d'une diode Zener, la gâchette du thyristor auxiliaire étant reliée à une borne de commande du circuit intégré et à ladite autre des deuxièmes bornes par l'intermédiaire d'une résistance, la cathode du thyristor auxiliaire étant connectée à une borne d'alimentation du circuit intégré et à ladite une des deuxièmes bornes par l'intermédiaire d'un condensateur de stockage, la gâchette du thyristor principal à gâchette d'anode étant reliée à une borne de commande du circuit intégré.

Dans un composant semiconducteur mettant en oeuvre ce module, le premier thyristor et le thyristor auxiliaire sont des thyristors verticaux dont la couche de gâchette de cathode est constituée d'un caisson de type P disposé dans un caisson de type P à plus faible niveau de dopage ; et le deuxième thyristor est un thyristor vertical à gâchette d'anode dont l'anode est constituée d'une couche de même type et niveau de dopage que les caissons de gâchette du premier thyristor et du thyristor auxiliaire, cette couche d'anode étant entourée d'un anneau de garde du même type de conductivité et à plus faible niveau de dopage.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
la figure 1 représente un circuit classique de démarrage de tube à fluorescence ;
la figure 2 représente un mode de réalisation d'un circuit de démarrage de tube à fluorescence selon la présente invention ;
les figures 3A à 3F représentent des courbes illustrant des allures de tension et de courant en divers points du circuit de la figure 2 ; et
les figures 4A et 4B représentent respectivement une vue en coupe schématique et une vue de dessus schématique d'un composant semiconducteur monolithique selon la présente invention de démarrage de tube fluorescent.

La figure 2 représente un mode de réalisation d'un circuit selon la présente invention. La deuxième borne A1 du filament r1 est connectée à l'anode d'un thyristor Th1 à gâchette de cathode et à la cathode d'un thyristor Th4 à gâchette d'anode. La deuxième borne A2 du filament r2 est connectée à la cathode du thyristor Th1 et à l'anode du thyristor Th4. La gâchette du thyristor Th1 est connectée à la borne A2 par une résistance RG et à la borne A1 par la connexion en série d'un thyristor Th2 et d'une diode Zener Z. La gâchette du thyristor Th2 est reliée à son anode par une résistance 15 et correspond à une borne G d'un circuit intégré de commande IC. La cathode du thyristor Th2 est connectée à une borne 2 qui correspond à une borne d'alimentation du circuit intégré IC et à une première borne d'un condensateur C1 connecté entre cette borne 2 et la borne A2. Le thyristor Th4 est commandé du côté anode par un courant positif. Une borne 4 du circuit intégré IC commande la gâchette de ce thyristor Th4. On a en outre représenté, entre les bornes principales des thyristors Th1 et Th4, une diode Zener de protection Z2 en série avec une diode en direct D2.

Dans une application pratique où la tension d'alimentation S correspond à une tension de secteur de valeur moyenne 220 volts, on pourra utiliser les composants suivants :
- tension d'avalanche de la diode Z : 10 volts,
- résistance R_{G} : 100 kohms,
- tension d'avalanche de la diode Z2 : entre 900 et 1500 V,
- capacité du condensateur C1 : 3 à 5 microfarads,
- thyristor Th2 : thyristor sensible commandable par un courant inférieur à 1 mA et capable de se bloquer si on lui applique une tension de gâchette négative,
- thyristor Th1 : thyristor de puissance dont le courant de seuil de blocage (IH1) est élevé, par exemple 350 mA,
- thyristor Th4 : thyristor à gâchette d'anode ayant par ailleurs des caractéristiques classiques.

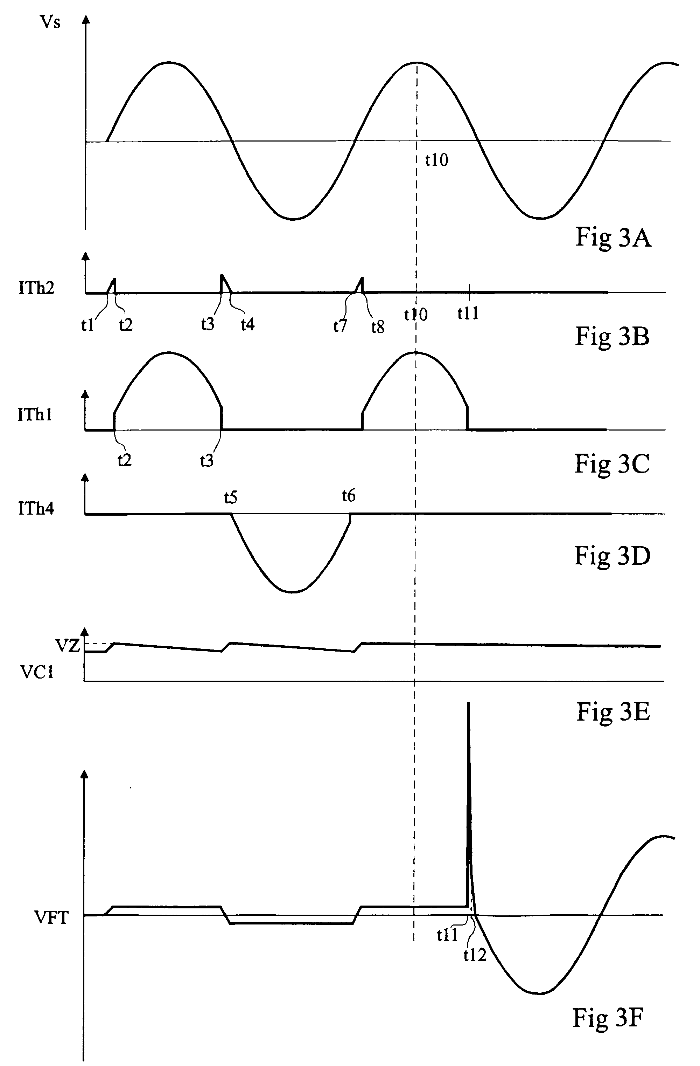

Le fonctionnement de ce composant se comprendra en relation avec les figures 3A à 3F dans lesquelles la période située avant un instant t10 correspond à un chauffage initial de filaments et la période suivant l'instant t10 correspond à un démarrage du tube fluorescent et à un fonctionnement ultérieur de celui-ci.

Dans le mode de chauffage, on trouve initialement entre les instants t1 et t2 une conduction du thyristor Th2 suivie d'une conduction du thyristor Th1 à un instant t2 où la tension aux bornes dépasse la tension d'avalanche de la diode Z. Comme le représente la courbe VC1 de la figure 3E, pendant la durée tl-t2, le condensateur C1 se charge. Puis pendant la période de conduction du thyristor Th2, le condensateur C1 se décharge très légèrement pour alimenter le circuit intégré IC. Pendant cette période, la tension VFT aux bornes du tube fluorescent reste sensiblement constante, et correspond à la chute de tension aux bornes du thyristor Th1, comme cela est représenté en figure 3F.

Comme on l'a indiqué précédemment, le thyristor Th1 a un courant de seuil de désamorçage IH1 élevé. Ainsi, à un instant t3 pour lequel la tension d'alimentation VS n'est pas négligeable, le thyristor Th1 se bloque et le thyristor Th2 se remet à conduire. Entre cet instant t3 et l'instant t4 de fin de l'alternance, le condensateur C1 se charge à nouveau. On obtient donc une charge très régulière du condensateur, sensiblement équilibrée en début et en fin d'alternance, et donc une alimentation régulière et sous faible tension du circuit intégré IC.

A un instant t5, le circuit intégré IC commande le thyristor Th4 pour qu'il devienne conducteur et, éventuellement après un léger retard, celui-ci entre en conduction comme le montre la courbe ITh4 de la figure 3D. Cette conduction s'arrête à un instant t6 pour lequel le courant est voisin de 0, ce thyristor présentant un courant de seuil de désamorçage IH4 faible. On notera que le courant de gâchette, positif, est fourni à la gâchette d'anode du thyristor Th4 par le circuit intégré à partir du condensateur C1 qui vient d'être rechargé.

Entre les instants t7 et t8, on retrouve la même allure qu'entre les instants t1 et t2.

On arrive alors à l'instant t10 auquel les filaments sont suffisamment chauffés et où l'on veut tenter d'amorcer le tube fluorescent FT. A l'instant t11 de désamorçage du thyristor Th1, le circuit intégré IC court-circuite la borne G et la borne A2 ; le thyristor Th2 voit la tension du condensateur C1 en inverse sur sa gâchette et se bloque ; l'inductance ballast L tend à maintenir le courant qui la traverse ; et la tension entre les bornes A1 et A2 croît rapidement jusqu'à la tension d'avalanche de la diode Z2 (voir figure 3F). Si tout se passe bien, le tube fluorescent s'allume et la tension à ses bornes est fixée par le courant imposé par la bobine. Cette dernière agit comme un générateur de créneaux de courant ; la tension aux bornes du tube tombe à environ 100 V. Cette tension est insuffisante pour redéclencher le circuit d'allumage qui reste en veille. Si le tube fluorescent ne se déclenche pas, la diode Z2 sert de protection et, quand sa tension d'avalanche est atteinte, elle entre en conduction, après quoi le phénomène décrit précédemment se répète à chaque fin d'alternance positive jusqu'à amorçage du tube fluorescent.

On notera que, pour la réalisation d'un composant semiconducteur mettant en oeuvre les fonctions réalisées par le circuit de la figure 2, il convient que les thyristors Th1 et Th2 puissent supporter une tension en direct élevée, supérieure à la tension d'avalanche de la diode Zener Z2 et que, en inverse, ces composants puissent supporter la tension du secteur. De même, le composant Th4 doit tenir plus que la tension d'avalanche de la diode Z2 en inverse et le secteur en direct.

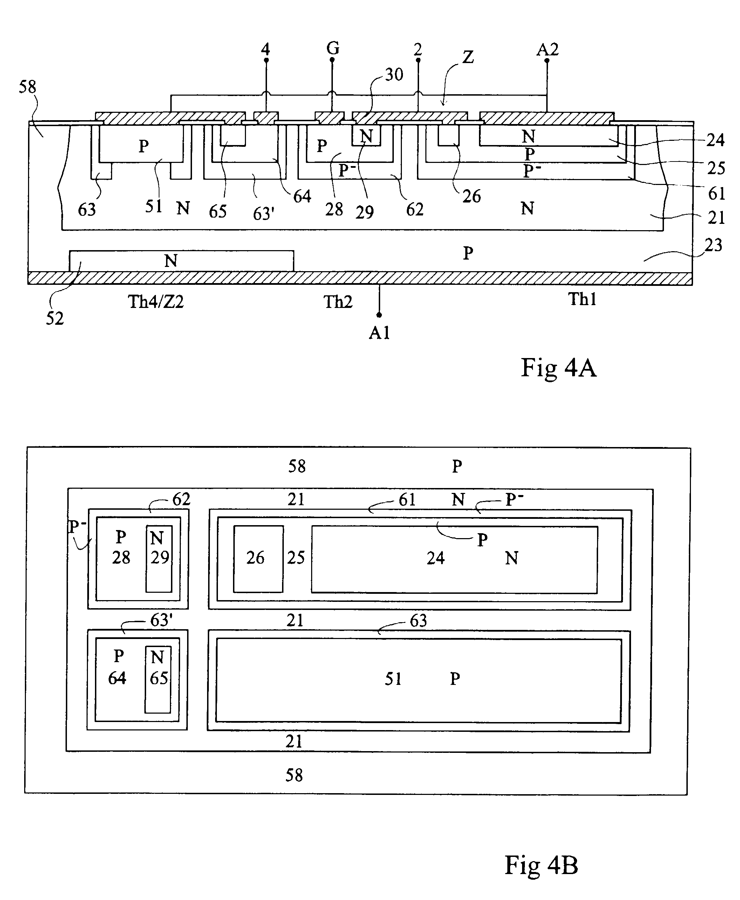

Les figures 4A et 4B représentent très schématiquement en coupe et en vue de dessus un exemple d'une telle réalisation permettant une tenue en tension élevée. La figure 4A est fortement schématique conformément à l'usage dans le domaine de la représentation des composants semiconducteurs. En outre, la vue de dessus de la figure 4B ne correspond pas strictement à la vue en coupe de la figure 4A. L'homme de métier saura adapter la surface et la topographie des diverses couches et régions pour optimiser les caractéristiques du composant et notamment la capacité de passage de courant et la tension Zener.

Le composant est formé à partir d'un substrat 21 de type N. La face arrière du composant comprend une couche 23 de type P revêtue d'une métallisation de face arrière A qui correspond à l'anode des thyristors Th1 et Th2. Le thyristor Th1 est réalisé sous forme verticale et comprend à partir de la face supérieure une couche de cathode 24 formée dans un caisson 25 de type P lui-même formé dans le substrat 21. Dans une portion du caisson 25 est formée une région 26 de type N qui constitue avec ce caisson une jonction Zener correspondant à la diode Z. Un deuxième caisson 28 de type P comprenant une région 29 de type N permet de former le thyristor Th2 sous forme verticale, ce thyristor comprenant les régions 29, 28, 21 et 23. La cathode 29 du thyristor Th2 est reliée par une métallisation 30 à la cathode 26 de la diode Z.

La métallisation 30 correspond à la borne 2 de la figure 2. Le caisson 28 est revêtu d'une métallisation de gâchette G. La résistance RG est constituée par la résistance de la région 25 sous la couche de cathode 24.

Un caisson 51 de type P est formé dans la partie supérieure du substrat. Du côté de la face inférieure, sous ce caisson 51 et une partie au moins de la région de gâchette 28, est formée une région 52 de type N. Les régions 51, 21, 23 et 52 forment le thyristor Th4. Une métallisation revêtant le caisson 51 est reliée à la métallisation couvrant la région 24 et forme l'électrode principale A2.

Au voisinage du caisson 51 est formée une région P 64 solidaire d'une métallisation de gâchette 4. Une région N 65 est formée dans la région 64 et est reliée par une métallisation à l'anode 51 du thyristor Th4. Lorsqu'une tension positive par rapport à la borne A2 est appliquée à la gâchette 4, un courant va circuler de la région 64 vers la région 65. Si la borne A1 est alors négative par rapport à la borne A2, le thyristor Th4 est en direct et va être amorcé.

Bien entendu, cette structure est susceptible des diverses améliorations et variantes. Ainsi, à titre d'exemple, on a représenté la structure entourée d'un caisson 58 de type P.

De plus, il est prévu de former certains au moins des caissons P du côté de la face supérieure dans une diffusion P- pour améliorer la tenue en tension des divers composants. Ainsi, le caisson 25 se trouve dans un caisson P- 61, le caisson 28 dans un caisson P- 62 et la région 64 dans un caisson P- 63'. L'anode 51 du thyristor Th4 est entourée d'un anneau P- 63. Cet anneau P- est suffisamment peu dopé par rapport à la couche 51 pour que la jonction entre la couche 51 et le substrat 21 claque à une tension plus basse que la jonction entre les différentes couches, de même dopage, 61, 62 et 63 et le substrat 21. Cette jonction entre la couche 51 et le substrat 21 constituera la diode Zener Z2. Cette diode Zener sera capable d'écouler l'énergie importante stockée dans la bobine car le claquage est en volume. On peut aussi par accroissement de sa surface augmenter son pouvoir d'écoulement. En conséquence, la couche 51 remplit à la fois le rôle d'anode du thyristor Th1 et le rôle d'anode de la diode Zener Z2 (sa cathode étant le substrat 21), la diode D2 étant entre la couche P 23 et le substrat N 21.

Les régions N 24 et 52 qui constituent les cathodes des thyristors Th1 et Th4 pourront être munies classiquement de courts-circuits d'émetteur. Ces courts-circuits sont notamment utilisés pour ajuster le courant de seuil de désamorçage IH1 du thyristor Th1. La densité de trous de court-circuit sera plus faible dans le thyristor Th4 pour ne pas réduire excessivement sa sensibilité.

La figure 4B illustre schématiquement un exemple de réalisation en vue de dessus du composant de la figure 4A. Les métallisations n'ont pas été représentées.

## Revendications

1. Module de démarrage d'un tube fluorescent associé à un circuit de charge comprenant une source d'alimentation alternative (S) en série avec une inductance ballast (L) et un premier et un deuxième filament (r1, r2) du tube fluorescent (FT), ledit module étant connecté entre les deuxièmes bornes (A1, A2) desdits filaments et comprenant :
entre lesdites deuxièmes bornes (A1, A2), un premier et un deuxième thyristor principal tête-bêche (Th1, Th4), respectivement à gâchette de cathode et à gâchette d'anode, et une diode Zener de protection (Z2) en série avec une diode (D2),
un circuit intégré de commande (IC),
la gâchette du premier thyristor principal (Th1) étant connectée à l'une (A2) des deuxièmes bornes et à sa cathode par l'intermédiaire d'une résistance (RG) et à l'autre (A1) des deuxièmes bornes par la connexion en série d'un thyristor auxiliaire (Th2) et d'une diode Zener (Z), la gâchette du thyristor auxiliaire étant reliée à une borne de commande du circuit intégré et à ladite autre des deuxièmes bornes par l'intermédiaire d'une résistance (15), la cathode du thyristor auxiliaire étant connectée à une borne (2) d'alimentation du circuit intégré et à ladite une des deuxièmes bornes par l'intermédiaire d'un condensateur de stockage (C1), la gâchette du thyristor principal à gâchette d'anode étant reliée à une borne de commande du circuit intégré.

2. Composant semiconducteur mettant en oeuvre le module de la revendication 1, caractérisé en ce que le premier thyristor principal (Th1) et le thyristor auxiliaire (Th2) sont des thyristors verticaux dont les régions de gâchette sont des caissons de type P (25 ; 28) disposés dans des caissons de type P à plus faible niveau de dopage (61 ; 62) ; et le deuxième thyristor principal (Th4) est un thyristor vertical dont l'anode est une région (51) de même type et niveau de dopage que les caissons de gâchette (25 ; 28) du premier thyristor et du thyristor auxiliaire, cette région d'anode (51) étant entourée d'un anneau de garde du même type de conductivité et à plus faible niveau de dopage (63).

## Patentansprüche

1. Starter-Modul einer Leuchtstoff-bzw. Fluoreszenzröhre, in Zuordnung zu einer Ladeschaltung, welche eine Speise-Wechselstromquelle (S) in Reihe mit einer Ballast-Induktivität (L) und einer ersten und zweiten Wendel (r1, r2) der Leuchtstoffröhre (FT) umfaßt, wobei der Modul zwischen den zweiten Anschlüssen (A1, A2) der genannten Wendel angeschlossen ist und umfaßt:
zwischen den genannten zweiten Anschlüssen (A1, A2) einen ersten und einen zweiten Hauptthyristor (Th1, Th4) in Antiparallelschaltung, mit einem Kathodengate bzw. einem Anodengate, sowie eine Schutz- Zenerdiode (Z2) in Reihe mit einer Diode (D2),
eine integrierte Steuerschaltung (IC),
wobei das Gate des ersten Hauptthyristors (Th1) mit dem einen (A2) der zweiten Anschlüsse und mit seiner Kathode über einen Widerstand (RG) und mit dem anderen (A1) der zweiten Anschlüsse über die Reihenschaltung eines Hilfsthyristors (Th2) und einer Zenerdiode (Z) verbunden ist, das Gate des Hilfsthyristors mit einem Steueranschluß der integrierten Schaltung verbunden und mit dem genannten anderen der zweiten Anschlüsse über einen Widerstand (15) verbunden ist, die Kathode des Hilfsthyristors mit einem Speiseanschluß (2) der integrierten Schaltung verbunden und mit dem genannten einen der zweiten Anschlüsse über einen Speicherkondensator (C1) verbunden ist, und das Gate des Hauptthyristors mit Anodengate mit einem Steueranschluß der integrierten Schaltung verbunden ist.

2. Halbleiterbauteil als Realisierung des Moduls nach Anspruch 1, dadurch gekennzeichnet, daß der erste Hauptthyristor (Th1) und der Hilfsthyristor (Th2) Vertikalthyristoren sind, deren Gatebereiche Gräben vom P-Typ (25; 28) sind, die in P-Gräben (61; 62) von niedrigerem Dotierungspegel angeordnet sind; und daß der zweite Hauptthyristor (Th4) ein Vertikalthyristor ist, dessen Anode ein Bereich (51) vom selben Dotierungstyp und Dotierungspegel wie die Gategräben (25; 28) des ersten Thyristors und des Hilfsthyristors ist und dieser Anodenbereich (51) von einem Schutzring (63) gleichen Leitfähigkeitstyps aber geringeren Dotierungspegels umgeben ist.

## Claims

1. A starter unit for a fluorescent tube associated with a load circuit including an A.C. supply source (S) in series with a ballast inductance (L) and a first and a second filament (r1, r2) of the fluorescent tube (FT), said unit being connected between the second terminals (A1, A2) of said filaments and including:
across said second terminals (A1, A2), first and second main thyristors (Th1, Th4) head-to-tail connected, respectively with a cathode gate and with an anode gate, and a zener protection diode (Z2) in series with a diode (D2),
a control integrated circuit (IC),
the gate of the first main thyristor (Th1) being connected to one (A2) of the second terminals and to its cathode through a resistor (RG) and to the other (A1) of the second terminals through the series connection of an auxiliary thyristor (Th2) with a zener diode (Z), the gate of the auxiliary thyristor being connected to a control terminal of the integrated circuit and to said other of the second terminals through a resistor (15), the cathode of the auxiliary thyristor being connected with a supply terminal (2) of the integrated circuit and to said one of the second terminals through a storing capacitor (C1), the gate of the anode-gate main thyristor being connected to a control terminal of the integrated circuit.

2. A semiconductor component implementing the unit of claim 1, characterized in that the first main thyristor (Th1) and the auxiliary thyristor (Th2) are vertical thyristors having their cathode gate regions formed by P-type wells (25; 28) disposed inside a lower doped P-type well (61; 62); and the second main thyristor (Th4) is an anode gate vertical thyristor having its anode formed by a layer (51) of the same type and same doping level as the gate wells (25; 28) of the first thyristor and of the auxiliary thyristor, said anode layer (51) being surrounded by a guard ring (63) having the same conductivity type as the anode with a lower doping level.
